# EUROPEAN PATENT APPLICATION

(11) **EP 4 632 488 A1**
(43) Date of publication of application: **15.10.2025**
(21) Application number: 24169182.3
(22) Date of filing: 09.04.2024
(51) Int. Cl.: G03F 7/20, G03F 9/00, G03F 7/00

(54) **A METHOD OF LITHOGRAPHY AND ASSOCIATED APPARATUSES**

(71) Applicant: ASML Netherlands B.V., 5500 AH Veldhoven (NL)
(72) Inventor: BRINKHOF, Ralph, 5500 AH Veldhoven (NL); LAMBREGTS, Cornelis, Johannes, Henricus, 5500 AH Veldhoven (NL); WERKMAN, Roy, 5500 AH Veldhoven (NL)
(74) Representative: ASML Netherlands B.V.

(57) **Abstract**

Disclosed is method of determining an actuatable correction for a lithographic process. The method comprises obtaining a modeled error and/or a requested correction, said modeled error relating to an error of said lithographic process and said requested correction comprising a requested correction for said modeled error; and determining said actuatable correction in dependence on from which layer the modeled error originates.

## Description

### FIELD

The present disclosure relates to processing of substrates for the production of, for example, semiconductor devices.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-k1 lithography may be used to process features with dimensions smaller than the classical resolution limit of a lithographic apparatus. In such a process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by metrology data associated with mark position. The metrology data are obtained from measurements of wafers. An example of such measurements are alignment measurements of alignment marks performed using an alignment system in a lithographic apparatus prior to exposure.

It is sometimes desirable to use a different model or class of lithographic apparatus for different layers of a single device. Such different classes of lithographic apparatus may have different actuation/correction capabilities and/or may have different field sizes.

It is therefore desirable to improve lithography methods, as used in the manufacture of ICs, and in particular such lithography methods performed using different lithographic apparatuses to manufacture a single device.

### SUMMARY

In a first aspect of the invention there is provided a method of determining an actuatable correction for a lithographic process, said method comprising: obtaining a modeled error and/or a requested correction, said modeled error relating to an error of said lithographic process and said requested correction comprising a requested correction for said modeled error; and determining said actuatable correction in dependence on from which layer the modeled error originates.

In a second aspect of the invention, there is provided interface for a lithographic apparatus being operable to receive: a first layer modeled error and/or first layer requested correction, the first layer modeled error relating to an error of a lithographic process originating from a first layer exposed on a substrate and the first layer requested correction comprising a requested correction for said first layer modeled error; and a second layer modeled error and/or second layer requested correction, the second layer modeled error relating to an error of a lithographic process originating from a second layer exposed on a substrate and the second layer requested correction comprising a requested correction for said second layer modeled error.

In a further aspect of the invention, there is provided a computer program comprising program instructions operable to perform the method of the first aspect when run on a suitable apparatus, and associated processing apparatus and lithographic apparatus.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an concepts disclosed herein;
Figure 4 is a flow diagram of a known control architecture used in a method of manufacturing IC devices;
Figure 5(a) illustrates a first control strategy for the exposure of three layers on a substrate, where the error is in the second layer; Figure 5(b) illustrates a second control strategy for the exposure of three layers on a substrate where the error is in the first layer and overlay between the first layer and second layer is more critical; and Figure 5(c) illustrates a third control strategy for the exposure of three layers on a substrate where the error is in the first layer and overlay between the second layer and third layer is more critical.
Figure 6 is a flow diagram of a control architecture used in a method of manufacturing IC devices according to concepts disclosed herein.

### DETAILED DESCRIPTION

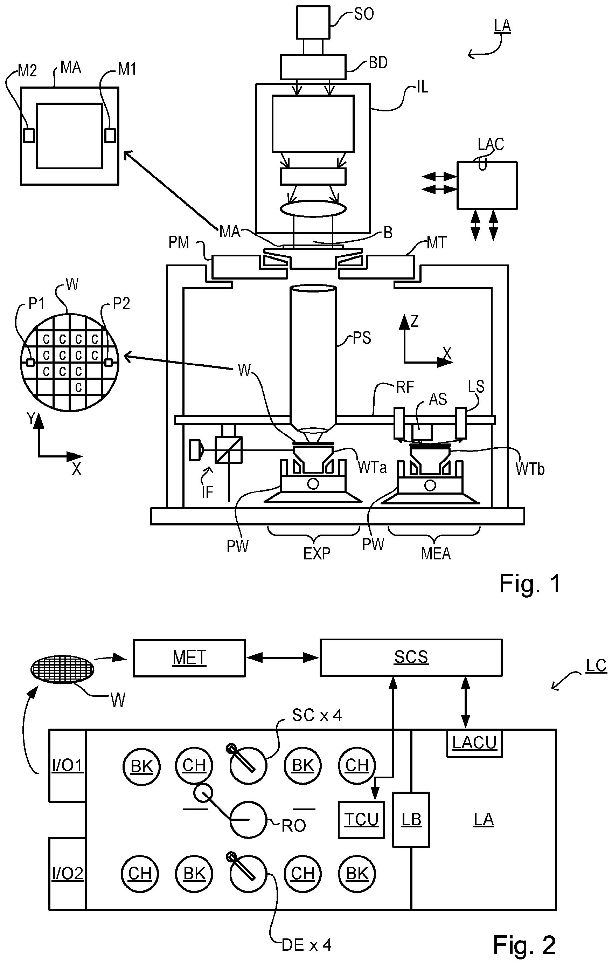

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement station-between which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. Due to inaccuracies in creating the marks and also due to deformations of the substrate that occur throughout its processing, the set of marks may next to translation and rotation have undergone more complex transformations. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

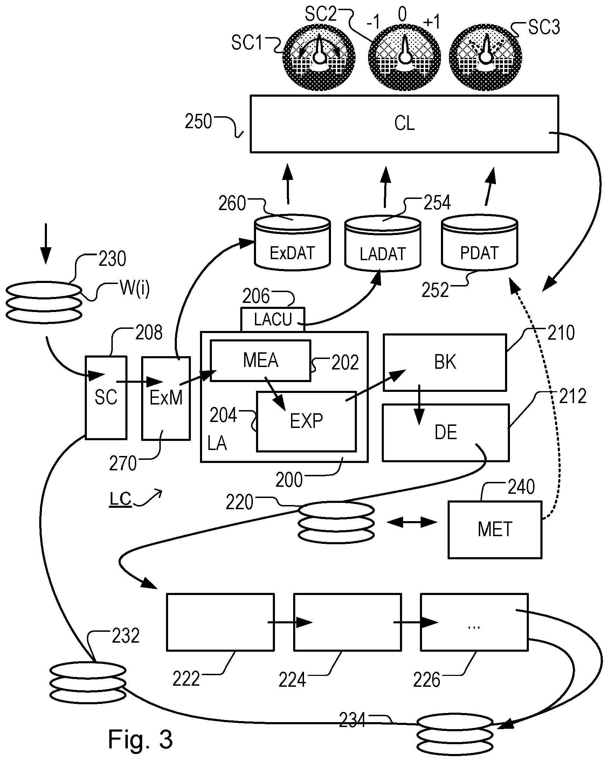

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a `dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist. Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Additionally, (e.g. stand-alone) external pre-exposure metrology tools ExM 270 may be used to make measurements before exposure on a lithographic apparatus. Such external pre-exposure metrology tools ExM 270 are distinct from the measurement station MEA 202 of a twin stage lithographic apparatus LA 200. Any pre-exposure measurements are also considered to be external measurements. To maintain exposure throughput at a sufficient level, the scanner metrology data LADAT (e.g., alignment grid and substrate deformation grid) measured by measurement station MEA 202 may be based on a sparser set of measurements as would be desirable. This typically means such a measurement station is incapable of gathering sufficient metrology data for higher order corrections, and particularly corrections beyond the third order. In addition to this, use of an opaque hard mask can make it difficult to accurately measure the wafer grid in alignment. It can be appreciated that, for an external pre-exposure metrology tools ExM 270, the throughput may be lower than that of the lithographic apparatus LA 200, e.g., provided that the measurements are performed before the substrate enters the lithocell.

External pre-exposure metrology tools ExM 270 enable much denser measurements to be made on each substrate, prior to exposure. Some of these pre-exposure metrology tools ExM 270 measure and/or predict wafer grid deformation at a throughput equal to or faster than the scanner, and with a measurement density much higher than can be achieved using an alignment sensor and level sensor, even when such sensors are comprised within a separate measurement station MEA 202. Pre-exposure metrology tools comprise, for example, substrate shape inspection tools and/or stand-alone alignment stations.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent alignment measurements over a wafer and/or over a field, an alignment model is used. A first purpose of an alignment model is to provide a mechanism for interpolating and/or extrapolating the available measurements data over the whole wafer, such that an expose grid can be created on each exposure field. The metrology data will be sparse as it is simply not practical to measure as many measurement regions as would be desirable from an overlay accuracy perspective: the time and therefore throughput overhead would be too high. A second purpose of an alignment model is to provide noise suppression. This may be achieved by using fewer model parameters than measurements or by using regularization.

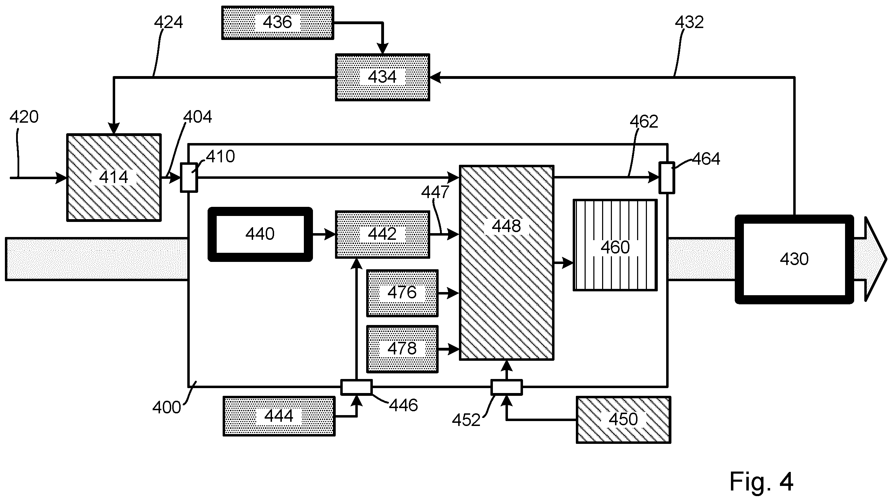

Figure 4 illustrates a known parameter of interest (e.g., overlay) control architecture. At a high level, the controlling a parameter of interest such as overlay in a lithographic exposure process may be broken down into four main aspects:
- Metrology: which may comprise pre-exposure metrology such as alignment metrology and/or post-exposure metrology such as overlay metrology. Each metrology function is shown as a white box with thick line 430, 440 in the Figure.
- Estimation: the fitting of a model to the metrology data, so as to best describe the actual distortion and/or deformation of the pattern on the substrate, thereby providing a modelled error; i.e., a modeled estimate of the distortion and/or deformation (e.g., therefore defining a requested or desired correction). Each estimation function is shown as a gray dot-shaded box 434, 436, 442, 444, 476, 478 in the Figure.
- Optimization: converting the requested or desired correction(s) into an actuatable correction (e.g., actions per exposure or determined trajectories) which can be actuated by the lithographic apparatus and which closely match the estimated correction (e.g., the requested correction). Each optimization function is shown as a diagonal hatched box 414, 448, 450 in the Figure.
- Actuation: Actuating the actuatable correction. The actuation function is shown as a vertical hatched box 460 in the Figure.

A feature of many present lithographic apparatuses is that there is limited functionality for inputting corrections into the lithographic apparatus 400. Typically, pre-optimized corrections 404 can only be inputted, e.g., via correction interface 410 if already converted to (e.g., actuatable) corrections per exposure. This requires an external optimization step 414 to be performed outside of the lithographic apparatus 400. This external optimization step 414 may comprise an optimization based on a requested feed-forward correction 420 (the determination of which is not shown) or a requested feedback correction 424. The requested feedback correction 424 may be determined from post-exposure (external) metrology 430, yielding parameter of interest (e.g., overlay) metrology data 432 from previously exposed substrates (e.g., from one or more previous lots). This metrology data 432 undergoes an estimation or model fitting step 434 (e.g., based on a model setup step 436) to determine the requested feedback correction 424; e.g., in terms of a "fingerprint", such as a model fitted to the metrology data or correction determined therefor. For example, the feedback correction 424 (and/or feed-forward correction 420) may comprise one or both of an inter-field correction or an intra-field correction.

Within the lithographic apparatus 400, alignment metrology 440 is performed and an estimation step 442 (alignment model fitting) performed to determine a correction (e.g., a requested correction). The estimation step 442 may comprise a corresponding alignment recipe setup step 444 with the recipe introduced via alignment recipe interface 446. The alignment corrections 447 and the pre-optimized corrections 404 are then used in an exposure optimization step 448 to determine an actuatable correction or corrections per exposure. The optimization 448 may initially be setup 450 and the optimization recipe introduced via optimization recipe interface 452. For example, how the actuatable corrections are optimized to best match the requested correction may depend on the setup 450, e.g., different optimization norms may be used and/or different balancing between different types of corrections such as overlay versus fading. Optimization residuals 462 may be outputted via residual interface 464 and used for process monitoring (e.g., as a performance indicator) for example. The actuatable correction can then be actuated 460 during an exposure. Once actuated and exposed, the resulting exposed substrates can be output from the lithographic apparatus 400 and (optionally) forwarded for external metrology 430.

In the above description, the optimization 448 is described only in terms of using on-product metrology data (e.g., overlay and alignment data) as these are the main datasets relevant to the present disclosure. However, the skilled person will realize that there may be many more datasets considered in the optimization 448, such as those based on prediction of heating effects (lens, reticle or wafer); here represented as lens-, substrate- or reticle heating feedforwards 476, 478, such that the optimized actuatable correction also include corrections for these predicted errors.

This present architecture means it is impractical or impossible to consider an origin of the distortion (or more generally, the error) being corrected for during exposure optimization step 448 and its supporting steps. The origin of the error may refer to which previously exposed (e.g., and etched) layer and/or which lithographic apparatus is responsible for introducing the error.

In particular, whether distortion is resulting from the first layer or bottom layer (e.g., a previously exposed and etched layer) or the second layer or top layer (e.g., the layer that is to be exposed and for which the actuatable correction is being determined) will have an impact in the correction capability/planning, in terms of these two layers and/or a third layer or next layer (to be exposed after the top layer). Distortion originating from the first layer or bottom layer may be as a result of one or more of: the substrate, the lithographic apparatus and exposure process and/or another manufacturing/processing apparatus or step such as an etch apparatus and etch process. Distortion originating from the second layer or top layer may be as a result of one or more of: the substrate (e.g., the resist layer) and/or the lithographic apparatus and exposure process.

In the present overlay control architecture, as depicted in Figure 4, the lithographic apparatus 400 only accepts external corrections within certain limits, essentially matching the actuation capability of the lithographic apparatus 400 (i.e., in the form of an actuatable correction). It is because of this that the optimization step 414 outside the scanner is required. Presently, the estimation step 434 models the overlay measurements 432 which describe the difference in wafer and/or field distortion between top and bottom layer only. This model typically does not account for from which layer the distortion originates.

Because the optimization algorithm 448 optimizes towards the total requested correction, the origin of individual error components is not taken into account. However, the optimal actuatable correction may depend on the whether the to-be-corrected distortion (error component) comes from the top layer (exposure layer or second layer) or from the bottom layer (previously exposed layer or first layer). In particular, this is relevant when different classes or types of lithographic apparatuses are used to expose respective different layers, the different classes or types of lithographic apparatuses having for example one or both of different field sizes and/or different actuation capabilities. Different actuation capability can result from one or more of: differences in available manipulators in the stages or projection optics, software differences and the use of different field sizes.

An improved control reference architecture is proposed which will comprise a new 'fingerprint interface' for the lithographic apparatus (e.g., an improved correction interface 410). This fingerprint interface will enable the lithographic apparatus to directly receive non-optimized corrections or requested corrections; e.g., the direct output of an overlay estimation step describing a desired correction (e.g., in terms of a fitted model) rather than only an actuatable correction. Such desired corrections may be based on sets of wafer and/or field model parameters as determined directly from a fitting of a model to metrology data (e.g., overlay measurements).

Lithographic process correction methods (e.g., computer implemented methods) are proposed herein which can take advantage of this improved control reference architecture by determining a correction (e.g., performing an optimization to determine an actuatable correction), e.g., within a lithographic apparatus, which takes into account the origin of individual error components of the error being corrected for (e.g., from which layer a respective error component of the error arises). For example, determining an origin of individual error components may determine whether an individual error component originates from a first layer (bottom layer) or second layer (top layer or to be exposed layer). Such methods may also take into account correction capabilities of the lithographic apparatus(es) used to expose one or more subsequent layers (i.e., subsequent to the first and second layers such at least a third layer).

In particular, for field related fingerprints, and where field sizes vary per layer, this enables the estimation step to distinguish between top and bottom layer error components (distortions).

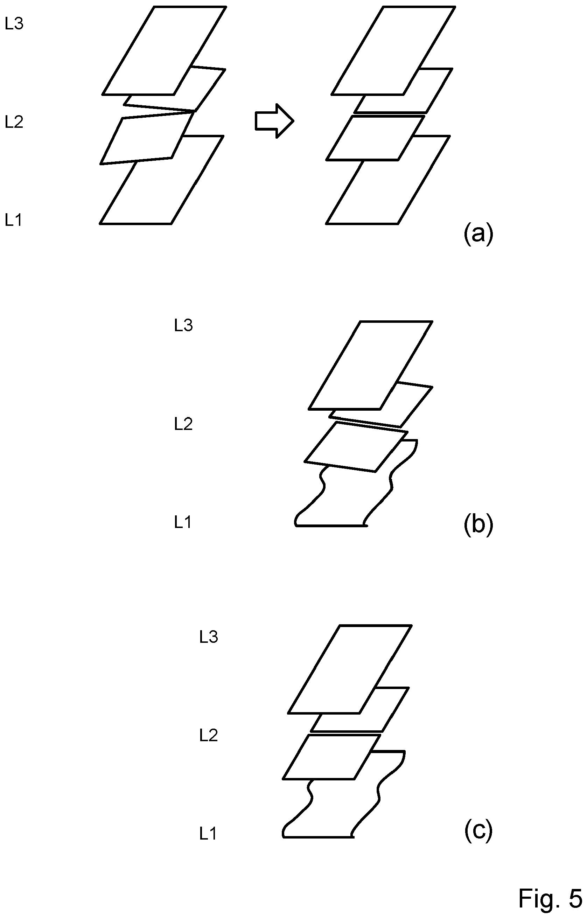

Figure 5 schematically illustrates three specific examples. In each example, there are three layers shown, where a first layer L1 and third layer L3 are exposed on a first lithographic apparatus type having a first correction capability and/or a first field size and layer L2 is exposed on a second lithographic apparatus type having a second correction capability and/or a second field size. By way of a specific example, the second field size is smaller (e.g., approximately half the size) of the first field size and/or the second correction capability is greater than the first correction capability.

Figure 5(a) illustrates a situation where the distortion originates from second layer L2, before (left) and after (right) correction. In such a case, it is proposed that the correction when exposing the second layer L2 is optimized and actuated with maximum available actuation capability, and as such the corrected second layer L2 will very closely follow the first layer L1. Figure 5(b) illustrates a situation where the distortion originates from first layer L1, and where overlay between second layer L2 and first layer L1 is most critical. As with the example of Figure 5(a), the correction when exposing the second layer L2 is optimized and actuated with maximum available actuation capability, and as such the corrected second layer L2 will very closely follow the first layer L1. 3. Figure 5(c) illustrates a situation where the distortion originates from first layer L1, and where overlay between third layer L3 and second layer L2 is most critical. In such an example, the actuation of the correction for layer L2 is limited, e.g., to use only the actuation capability available when exposing layer L3, such that the exposure of L3 can follow the actuated profile of layer L2.

While it can be appreciated that the examples of Figure 5(a) and Figure 5(b) are essentially the same as presently performed, in this case they are each an actively chosen strategy based on a determination of where an error component originates. The approach of Figure 5(c) is presently not used.

In an embodiment, a balanced approach between the approach described by Figure 5(b) and the approach described by Figure 5(c) can be used, e.g., to ensure that both overlay metrics (between third layer L3 and second layer L2 and between second layer L2 and first layer L1) are maintained within specification. A method for balancing correction to maintain both overlay metrics in specification is described, for example, US2020/0278614 which is incorporated herein by reference.

Briefly, US2020/0278614 describes a method for determining a plurality of corrections for control of at least one manufacturing apparatus (e.g., lithographic apparatus and/or etch apparatus) used in a manufacturing process, the method comprising: determining a correction for each layer based on an actuation potential of the applicable manufacturing apparatus used in the formation of each layer such that each applicable manufacturing apparatus is able to actuate a desired correction within specification and/or to maximize the probability that the device will be functional. The determining step may comprise determining corrections for each layer of a stack (two or more layers) simultaneously in terms of a matching parameter such as overlay, critical dimension uniformity or edge placement error of the product structures. The determining step may comprise determining the corrections based on a criticality metric or process window for one or more of said layers. The determining step may comprise applying a weighting imposing a relative importance to one or more of said corrections based on the criticality metric(s). For example, where the subset of layers comprises two layers, instead of always determining corrections in terms of correcting the upper layer placement to the lower layer placement, the optimization may include optimizing placement of the two layers for best layer alignment, taking into account the correction potential of the lithographic apparatus (or respective lithographic apparatuses if different apparatuses are used to expose different layers). Such an optimization may result in a placement correction for the lower layer instead of, or in addition to, a placement correction for the upper layer, so as to maximize the probability that the final device will function. Such an approach can be applied to stacks of more than two layers, optimizing the placement of structures within these layers. It can be appreciated that the disclosure of US2020/0278614 does not suggest making the optimization result dependent on the source of an error component, as is disclosed herein.

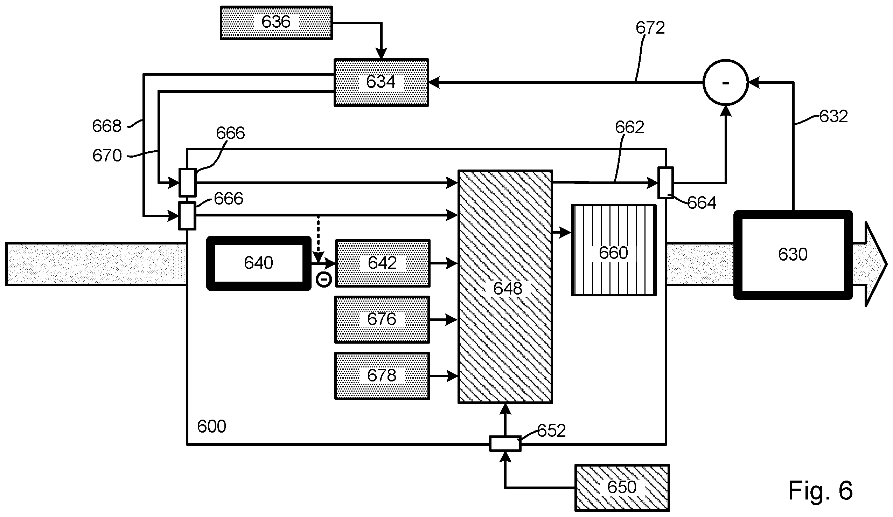

Figure 6 schematically illustrates an example parameter of interest (e.g., overlay) control architecture which may be used to implement the methods disclosed herein. In this architecture, a modified or improved correction interface 666 is provided which enables pre-optimized corrections 668, 670 to be directly introduced into the lithographic apparatus 600 without any need for an external optimization step. As before, previously exposed substrates (e.g., of one or more previous lots) are measured 630 to obtain parameter of interest metrology data 632. The pre-optimized corrections 668, 670 may comprise requested corrections, fingerprints or the modeled error (e.g., models fitted to the parameter of interest metrology data) which describe the parameter of interest metrology data and/or a correction therefor.

Optionally, optimization residuals 662, output from residual interface 664, may be subtracted from the parameter of interest metrology data 632. These residuals 662 represent a portion of the desired correction which cannot be actuated within the lithographic apparatus 600. Repeatedly requesting the lithographic apparatus 600 to try to actuate unactuatable corrections results in an escalation of the unactuatable requests. This is undesirable, as such an escalation will have a negative impact on imaging because the balancing in the optimization function will put more and more weight on correcting the (unactuatable) overlay, at the cost of for example fading, or higher order lens aberrations. Therefore, in each iteration of the feedback loop, the non-actuated portion from the metrology data is removed.

An estimation step 634, e.g., with associated setup step 636, fits one or more models to the metrology data 632 or the processed metrology data 672 (i.e., having had the residuals 662 removed). However, in contrast to estimation step 434 of Figure 4, this step separates the modeled error and/or a requested correction therefor into a first layer modeled error or requested correction component 668 (e.g., an error or correction component originating from the first or bottom layer) and a second layer modeled error or requested correction component 670 (e.g., an error or correction component originating from the second or top layer). This can be achieved in a number of different ways. For example, if the two layers have different field sizes, then there will be field-size dependent model parameters which are different for the two layers (e.g., intra field magnification, average intra-field or typical field to field fingerprint induced by wafer heating). As such, different models can be fitted to the metrology data to separate the error components (e.g., model separately for full-field and half-field magnification). This can be done without additional input if the field size is different between top and bottom layer. Another method for separating the error/correction components may comprise using expert knowledge, i.e., it may be known which distortions occur in layer, e.g., a warpage component present in bottom layer and a heating component present in the top layer. As such, knowledge of the processing steps applied may be used to indicate the origin of the distortion. It is also possible to use types of metrology which directly measure distortion individually in each layer (e.g., measuring a pair of adjacent gratings, one per layer, rather than overlaid gratings). Such a method may measure absolute overlay per layer (e.g., using alignment measurements or absolute on-target overlay measurements).

The optimization step 648 can use the individual error or correction component 668, 670, indicating the modelled origin of the distortion. By way of a specific example relevant to the layer arrangement of Figure 5, when determining actuatable corrections based on the second or top layer error or correction component 670, the full actuation capability of the lithographic apparatus 600 may be used. However, when determining actuatable corrections based on the first or bottom layer error or correction component 668, a different approach may be used depending on the respective process windows or criticality of overlay between the first layer and second layer with respect to overlay between the second layer and a subsequent or third layer and which takes into account the actuation limitations of the next layer. In a simple example, if the second layer to first layer overlay is more critical, the full actuation capability of the lithographic apparatus 600 may be used, while if the third layer to second layer overlay is more critical, less than the full actuation capability of the lithographic apparatus 600 is used, e.g., using an actuation capability of and/or based on that available for the third layer. In this way, the corrections in the second layer can be better followed when exposing the third layer.

As such, it is proposed that the optimization 648 may use a balanced actuation capability, which takes into account the actuation limitations of the third layer. For example, one relatively simple way of realizing this would be to apply a filter on the total bottom layer corrections (alignment corrections and bottom layer overlay corrections), prior to the optimization step 648. An alternative approach would be to optimize a combined cost function for the two types of corrections. A setup step 650 outside the lithographic apparatus 600 may be used to determine the balanced optimization settings, which can be introduced via a setup interface 652.

For example, to limit the actuatable correction to that actuatable in the next layer, the optimization 648 may apply the optimization algorithm which is to be used on the third layer. Another approach may apply a filter which removes content that cannot be actuated during the third layer exposure. A typical example may be third order variation in slit direction, which can be actuated on a DUV lithography system, but not on an EUV lithography system, while another example may be the intra-field content of the half-fields (half-sized or smaller than typical sub-regions) which cannot be actuated on full field apparatus. A combined cost function may comprise a minimization function that takes into account different minimization objectives based on the different actuation capabilities per layer. This is similar in principle to present optimizations, which take into account different objectives, e.g., overlay vs. fading or m+3σ vs. absmax (the proposed optimization 648 can also do this of course). For example, a penalty may be imposed on the bottom-layer requested correction only, which penalizes not adhering to the third layer actuation.

As is conventional, alignment metrology 640 is performed and modeled 642 to determine alignment corrections for the second layer exposure (and for every other layer). Prior to the alignment modeling/estimation step 642, the first layer corrections 668 may be subtracted (indicated by the dashed line in the Figure 6) from the alignment measurements, to reduce the risk of double-correction, as each relates to (largely the same) first layer distortions.

As before, the determined actuatable correction output from the optimization step 648 is then actuated 660 during an exposure (e.g., of the top/second layer). Once again, the setup 650 may determine how the optimization matches the requested correction, e.g., different optimization norms may be used and/or different balancing between different types of corrections such as overlay versus fading.

A balanced actuation may also be applied for the alignment corrections, which also measure towards an underlying layer and are aimed at following an existing distortion in and/or on the substrate. Other exposure corrections, such as lens-, substrate- or reticle heating feedforwards 676, 678, should be corrected with full actuation capability.

While it is proposed that the layer aware optimization step 648 is performed within lithographic apparatus 600, it can also be appreciated that this optimization step 648 can also be performed outside the lithographic apparatus 600.

Illustrative examples of the technologies disclosed herein are provided below. An embodiment of the technologies may include any one or more, and any combination of, the examples described below.

Example 1 comprises a method of determining an actuatable correction for a lithographic process, said method comprising: obtaining a modeled error and/or a requested correction, said modeled error relating to an error of said lithographic process and said requested correction comprising a requested correction for said modeled error; and determining said actuatable correction in dependence on from which layer the modeled error originates.

Example 2 includes the example of claim 1, wherein said determining the actuatable correction step comprises determining whether said modeled error originates from a first layer or a second layer on a substrate, wherein said second layer is to be exposed by said lithographic process onto said first layer.

Example 3 includes the example of claim 2 , wherein said obtaining a modeled error and/or requested correction comprises obtaining a first layer modeled error and/or requested correction component comprising a component of said modeled error and/or a requested correction originating from the first layer and a second layer modeled error and/or requested correction component comprising a component of said modeled error and/or requested correction originating from the second layer.

Example 4 includes the example of 3, wherein said actuatable correction comprises a correction for exposure of said second layer.

Example 5 includes the example of 3 or 4, wherein said first layer has been exposed using a first lithographic apparatus and said second layer is to be exposed using a second lithographic apparatus, wherein said first lithographic apparatus comprises a different field size and/or a different actuation capability to said second lithographic apparatus.

Example 6 includes the example of 5, wherein said step of determining said actuatable correction is performed within said second lithographic apparatus.

Example 7 includes the example of 5 or 6, wherein said determining said actuatable correction step comprises determining said actuatable correction in dependence of an actuation capability of a third lithographic apparatus to be used to expose a third layer on said substrate, the actuation capability of the third lithographic apparatus being different to at least the actuation capability of the second lithographic apparatus.

Example 8 includes the example of 7, comprising treating said first layer modeled error and/or requested correction and said second layer modeled error and/or requested correction differently in determining said actuatable correction, in dependence on the actuation capability of the third lithographic apparatus.

Example 9 includes the example of 7 or 8, wherein the first lithographic apparatus and the third lithographic apparatus comprises one or both of: a more limited actuation capability and/or a larger field size than the second lithographic apparatus.

Example 10 includes the examples of 7 to 9, wherein the first lithographic apparatus and the third lithographic apparatus comprise the same lithographic apparatus or the same type of lithographic apparatus.

Example 11 includes the examples of 7 to 10, wherein determining the actuatable correction comprises determining the actuatable correction for the first layer error or requested correction component using a balanced actuation capability, being balanced between the actuation capability of the second lithographic apparatus and the actuation capability of the third lithographic apparatus.

Example 12 includes the example of 11, wherein the balancing of the balanced actuation capability is determined in dependence of a relative criticality and/or importance of a parameter of interest relating to the first layer and second layer and the parameter of interest relating to the second layer and third layer.

Example 13 includes the example of 12, wherein said parameter of interest is overlay.

Example 14 includes the examples of 5 to 13, wherein determining the actuatable correction comprises determining the actuatable correction for the second layer error or requested correction component using the full actuation capability of the second lithographic apparatus.

Example 15 includes the examples of 3 to 14, comprising subtracting first layer modeled error and/or requested correction component from alignment metrology data prior to determining alignment corrections for exposing said second layer.

Example 16 includes the examples of 3 to 15, comprising fitting a model to metrology data relating to previous exposures of said second layer and said first layer to obtain said modeled error.

Example 17 includes the example of 16, comprising a step of separately determining said first layer modeled error and/or requested correction component and said second layer modeled error and/or requested correction component from said metrology data.

Example 18 includes the example of 16 or 17, comprising subtracting optimization residuals from said metrology data prior to said fitting a model and/or separately determining step, said optimization residuals comprising an unactuatable component of the modeled error and/or requested correction.

Example 19 includes the examples of 4 to 18, wherein said determining the actuatable correction comprises determining feedforward corrections for one or more of lens, substrate or reticle heating using the full actuation capability of the second lithographic apparatus.

Example 20 includes the any of the previous examples, wherein said actuatable correction comprises one or both of an interfield correction and/or an intrafield correction.

Example 21 includes the any of the previous examples, wherein said method comprises a computer implemented method.

Example 22 includes the any of the previous examples, comprising performing an exposure using the actuatable correction.

Example 23 comprises a computer program comprising program instructions operable to perform the method described by any of the Examples 1 to 22, when run on a suitable apparatus.

Example 24 is a non-transient computer program carrier comprising the computer program of Example 23.

Example 25 is a processing arrangement comprising: the non-transient computer program carrier of Example 24; and a processor operable to run the computer program comprised on said non-transient computer program carrier.

Example 26 comprises a lithographic apparatus comprising: a patterning device support for supporting a patterning device; a substrate support for supporting a substrate; and a processing arrangement of Example 25.

Example 27 comprises the lithographic apparatus of Example 26, further comprising an interface operable to receive: a first layer modeled error and/or first layer requested correction, the first layer modeled error relating to an error of a lithographic process originating from a first layer exposed on a substrate and the first layer requested correction comprising a requested correction for said first layer modeled error; and a second layer modeled error and/or second layer requested correction, the second layer modeled error relating to an error of a lithographic process originating from a second layer exposed on a substrate and the second layer requested correction comprising a requested correction for said second layer modeled error.

Example 28 comprises an interface for a lithographic apparatus being operable to receive: a first layer modeled error and/or first layer requested correction, the first layer modeled error relating to an error of a lithographic process originating from a first layer exposed on a substrate and the first layer requested correction comprising a requested correction for said first layer modeled error; and a second layer modeled error and/or second layer requested correction, the second layer modeled error relating to an error of a lithographic process originating from a second layer exposed on a substrate and the second layer requested correction comprising a requested correction for said second layer modeled error.

Example 29 includes the interface of example 28; and a computer program comprising program instructions operable to perform the method described by any of the Examples 1 to 22.

Example 30 includes the interface of example 29; and a processing arrangement comprising: a non-transient computer program carrier comprising said computer program; and a processor operable to run the computer program.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of determining an actuatable correction for a lithographic process, said method comprising:
obtaining a modeled error and/or a requested correction, said modeled error relating to an error of said lithographic process and said requested correction comprising a requested correction for said modeled error; and
determining said actuatable correction in dependence on from which layer the modeled error originates.

2. A method as claimed in claim 1, wherein said determining the actuatable correction step comprises determining whether said modeled error originates from a first layer or a second layer on a substrate, wherein said second layer is to be exposed by said lithographic process onto said first layer.

3. A method as claimed in claim 2, wherein said obtaining a modeled error and/or requested correction comprises obtaining a first layer modeled error and/or requested correction component comprising a component of said modeled error and/or a requested correction originating from the first layer and a second layer modeled error and/or requested correction component comprising a component of said modeled error and/or requested correction originating from the second layer.

4. A method as claimed in claim 3, wherein said first layer has been exposed using a first lithographic apparatus and said second layer is to be exposed using a second lithographic apparatus, wherein said first lithographic apparatus comprises a different field size and/or a different actuation capability to said second lithographic apparatus.

5. A method as claimed in claim 4, wherein said determining said actuatable correction step comprises determining said actuatable correction in dependence of an actuation capability of a third lithographic apparatus to be used to expose a third layer on said substrate, the actuation capability of the third lithographic apparatus being different to at least the actuation capability of the second lithographic apparatus.

6. A method as claimed in claim 5, comprising treating said first layer modeled error and/or requested correction and said second layer modeled error and/or requested correction differently in determining said actuatable correction, in dependence on the actuation capability of the third lithographic apparatus; wherein the first lithographic apparatus and the third lithographic apparatus comprises one or both of: a more limited actuation capability and/or a larger field size than the second lithographic apparatus.

7. A method as claimed in claim 5 or 6, wherein determining the actuatable correction comprises determining the actuatable correction for the first layer error or requested correction component using a balanced actuation capability, being balanced between the actuation capability of the second lithographic apparatus and the actuation capability of the third lithographic apparatus.

8. A method as claimed in claim 7, wherein the balancing of the balanced actuation capability is determined in dependence of a relative criticality and/or importance of a parameter of interest relating to the first layer and second layer and the parameter of interest relating to the second layer and third layer.

9. A method as claimed in any of claims 4 to 8, wherein determining the actuatable correction comprises determining the actuatable correction for the second layer error or requested correction component using the full actuation capability of the second lithographic apparatus.

10. A method as claimed in any of claims 3 to 9, comprising subtracting first layer modeled error and/or requested correction component from alignment metrology data prior to determining alignment corrections for exposing said second layer.

11. A method as claimed in any of claims 3 to 10, comprising fitting a model to metrology data relating to previous exposures of said second layer and said first layer to obtain said modeled error; and separately determining said first layer modeled error and/or requested correction component and said second layer modeled error and/or requested correction component from said metrology data.

12. A method as claimed in claim 11, comprising subtracting optimization residuals from said metrology data prior to said fitting a model and/or separately determining step, said optimization residuals comprising an unactuatable component of the modeled error and/or requested correction.

13. A computer program comprising program instructions operable to perform the method of any of claims 1 to 12, when run on a suitable apparatus.

14. A lithographic apparatus comprising:
a patterning device support for supporting a patterning device;
a substrate support for supporting a substrate;
a processing arrangement comprising a computer program comprising program instructions operable to perform the method of any of claims 1 to 12.

15. An interface for a lithographic apparatus being operable to receive:
a first layer modeled error and/or first layer requested correction, the first layer modeled error relating to an error of a lithographic process originating from a first layer exposed on a substrate and the first layer requested correction comprising a requested correction for said first layer modeled error; and
a second layer modeled error and/or second layer requested correction, the second layer modeled error relating to an error of a lithographic process originating from a second layer exposed on a substrate and the second layer requested correction comprising a requested correction for said second layer modeled error.
